# EUROPEAN PATENT SPECIFICATION

(11) **EP 1 531 360 B1**
(45) Date of publication and mention of the grant of the patent: **02.01.2008**
(21) Application number: 04292683.2
(22) Date of filing: 12.11.2004
(51) Int. Cl.: G03F 1/16

(54) **Stencil mask and method of producing the same**
Lochmaske und Verfahren zu ihrer Herstellung
Masque stencil et procédé de sa fabrication

(30) Priority: 12.11.2003 JP 2003382259
(43) Date of publication of application: 18.05.2005
(73) Proprietor: Sony Corporation, Tokyo (JP); ROHM CO., LTD., Kyoto (JP)
(72) Inventor: Hirakawa, Tadahiko, Sawara-ku Fukuoka-shi Fukuoka (JP); Kumano, Hiroshi, Ukyo-ku Tokyo (JP)
(74) Representative: Thévenet, Jean-Bruno

(56) References cited:
- US-A- 4 022 927
- US-A- 5 728 492
- US-A1- 2001 046 646

## Description

### BACKGROUND OF THE INVENTION

### 1. Field of the Invention

The present invention relates to a stencil mask, in particular a stencil mask used for a technology of manufacturing semiconductor using a charged particle beam.

### 2. Description of the Related Art

In recent years, miniaturization and high integration of semiconductor devices have progressed more and more. A technology of manufacturing a semiconductor, performing a process of sub-quarter micrometer at a high accuracy and repeatability is strongly required. As a technology of manufacturing the semiconductor, there is known a direct-drawing method according to which microscopic patterns are drawn by scanning with an electron beam and so on, when forming microscopic patterns on a wafer, in other words a semiconductor substrate.

However, since the processing time of a direct-drawing method is very long, by performing exposure with use of a stencil mask having aperture patterns in the thin film, an electron beam and so on is irradiated to the wafer selectively and microscopic patterns are formed, and accordingly a reduction of the processing time is intended.

A stencil mask may be used for several applications such as not only an exposure process, but an ion implantation process, a process of forming a film and so on. For example, a stencil mask may be applied to an ion implantation process. An example where an ion is selectively implanted by irradiating an ion beam to a processing substrate through a stencil mask placed on the upper side of the processing substrate is reported (For example, refer to Japanese Unexamined Patent Publication No. 1999-288680).

Since by using a stencil mask for an ion implantation process a resist pattern may not be formed on a processing substrate, then, resist coating before an ion implantation, exposure, patterning by developing and resist stripping after an ion implantation, can be reduced, and an ion implantation process in a short time becomes possible. Moreover, since wet-etching when developing or resist stripping may not be performed because of not forming a resist mask, generation of residual by wet-etching can be prevented, as a result surface contamination of the wafer is avoided.

However, since ions are irradiated to a stencil mask placed on a processing substrate, the temperature of the stencil mask rises significantly, components of the mask easily expand, warpage or distortion is easily generated in the stencil mask. To prevent deformation of the stencil mask like this, as an example, an electric conductive layer having high heat conductance on the surface of a stencil mask is formed and heat is radiated (refer to Japanese Unexamined Patent Publication No. 1997-5985).

However, the stencil mask is normally used in a vacuum condition. Generally, the radiation of the heat generated in the surface of the stencil mask to vacuum tends to be difficult. Therefore, if for a stencil mask an electric conductive layer having high heat conductance as mentioned above is placed on the upper side of a processing substrate and a charged particle beam is irradiated to a processing substrate through this stencil mask, the heat generated on the surface of the stencil mask is hard to radiate from an electric conductive layer to vacuum, hence deformation of the stencil mask by the heat cannot be prevented sufficiently.

US patent 5 728 492 discloses a mask for a projection system using a charged particle beam.

### SUMMARY OF THE INVENTION

To overcome the above problems, a stencil mask of the present invention comprises a thin film having an aperture pattern and a supporting substrate supporting the portion around the edge of said thin film and is characterized in that it further comprises a plug that is embedded in a state of contacting said thin film and reaches inside of said supporting substrate and has heat conductance higher than that of said thin film and said supporting substrate.

According to a stencil mask of the present invention, a plug having heat conductance higher than that of the thin film and the supporting substrate is embedded in a state of contacting the thin film and reaches inside of the supporting substrate. Here, the stencil mask is normally used in a vacuum condition. In a vacuum condition, generally, the heat generated in the surface of a stencil mask has a tendency that radiation into vacuum is faster than radiation inside a stencil mask. Hence, by irradiating a charged particle beam, the heat generated in the surface of the stencil mask can be radiated to the supporting substrate through the plug quickly.

Moreover, in the case that a material layer having heat conductance higher than that of the thin film in the side of the principal surface of the thin film is set, the heat generated in the surface of the thin film by irradiating the charged particle beam is radiated from the material layer directly. Further, in the case that this material layer is communicated with the plug, the heat generated in the surface of the thin film is radiated from the thin film to the material layer, and is radiated from the material layer to the supporting substrate through the plug more quickly.

Moreover, a first method of producing a stencil mask in the present invention comprises a step of forming an aperture portion in a portion around the edge of a supporting substrate, a step of forming a plug having heat conductance higher than that of a thin film and said supporting substrate at said aperture portion, a step of forming a thin film on the supporting substrate to cover the upper side of said plug, a step of forming an aperture pattern reaching said supporting substrate in said thin film covering inside the portion where the aperture portion is formed around the edge of said supporting substrate, and a step of removing a portion of the supporting substrate inside the portion around the edge of said supporting substrate to expose said thin film.

According to such a first method of producing the stencil mask, the plug having heat conductance higher than that of the thin film and the supporting substrate at the aperture portion set in the portion around the edge of the supporting substrate is formed. Herewith, a stencil mask where the heat generated in the surface of the thin film of the stencil mask can be radiated to the supporting substrate quickly through the plug can be produced.

Further, a second method of producing the stencil mask of the present invention comprises a step of forming a thin film on a supporting substrate, a step of forming an aperture pattern reaching said supporting substrate in said thin film covering inside a portion around the edge of said supporting substrate and forming an aperture portion reaching inside of said supporting substrate in said thin film covering the portion around the edge of said supporting substrate a step of forming a plug having heat conductance higher than that of said thin film and said supporting substrate at said aperture portion, and a step of removing a portion of the supporting substrate inside the portion around the edge of said supporting substrate to expose said thin film.

According to such a second method of producing the stencil mask, a plug having heat conductance higher than that of the thin film and the supporting substrate is formed at the aperture portion that penetrates the thin film covering the portion around the supporting substrate and that reaches inside of the supporting substrate. Herewith, a stencil mask where the heat generated in the surface of the thin film of the stencil mask can be radiated to the supporting substrate quickly through the plug can be produced. Moreover, in the case of forming the material layer having heat conductance higher than that of the thin film on the side of the principal surface of the thin film, by making this material layer to be communicated with the plug, a stencil mask where the heat generated in the surface of the thin film of the stencil mask can be radiated into the supporting substrate more quickly through the material layer and the plug can be produced. Further, by forming this material layer and the plug with the same material, the material layer and the plug can be formed with the same process.

According to the stencil mask of the present invention, since the plug having heat conductance higher than that of the thin film and the supporting substrate is embedded in a state of contacting the thin film and reaches inside of the supporting substrate, the heat generated in the surface of the thin film by irradiating a charged particle beam can be radiated into the supporting substrate quickly through the plug. Hence deformation such as warpage or distortion by the heat of the stencil mask can be prevented. Therefore, when placing the stencil mask at a predetermined distance on the upper side of the processing substrate, the stencil mask is prevented from contacting the processing substrate by deformation by the heat and the interval between the processing substrate and the stencil mask in the entire region of the processing substrate can be kept. Further, since deformation of the aperture pattern by the heat can be prevented, displacement and deformation in the irradiating region of the charged particle beam can be prevented.

Moreover, according to the first method of producing the stencil mask of the present invention, the plug having heat conductance higher than that of the thin film and the supporting substrate is formed at the aperture portion set in the portion around the edge of the supporting substrate. Hence, a stencil mask where the heat generated in the surface of the thin film of the stencil mask can be radiated into the supporting substrate quickly through the plug can be produced.

Further, according to the second method of producing the stencil mask of the present invention, since the plug having heat conductance higher than that of the thin film and the supporting substrate is formed at the aperture portion that penetrates the thin film covering the portion around the edge of the supporting substrate and that reaches inside of the supporting substrate, an effect similar to the first method of producing can be obtained. Moreover, in the case of forming the material layer having heat conductance higher than that of the thin film on the side of the principal surface of the thin film, by making this material layer to be in communication with the plug, a stencil mask where the heat generated in the surface of the thin film of the stencil mask can be radiated in the supporting substrate more quickly through the material layer and the plug can be produced. Further, by forming this material layer and the plug with the same material, the material layer and the plug can be formed with the same process.

### BRIEF DESCRIPTION OF THE DRAWINGS

FIG. 1A and FIG. 1B are cross sectional views of a stencil mask according to an embodiment of the present invention.
FIG. 2A to FIG. 2S are cross sectional process views showing a process of producing a stencil mask according to the present embodiment.

### DESCRIPTION OF THE PREFERRED EMBODIMENTS

Preferred embodiments of the present invention will be described with reference to the accompanying drawings.

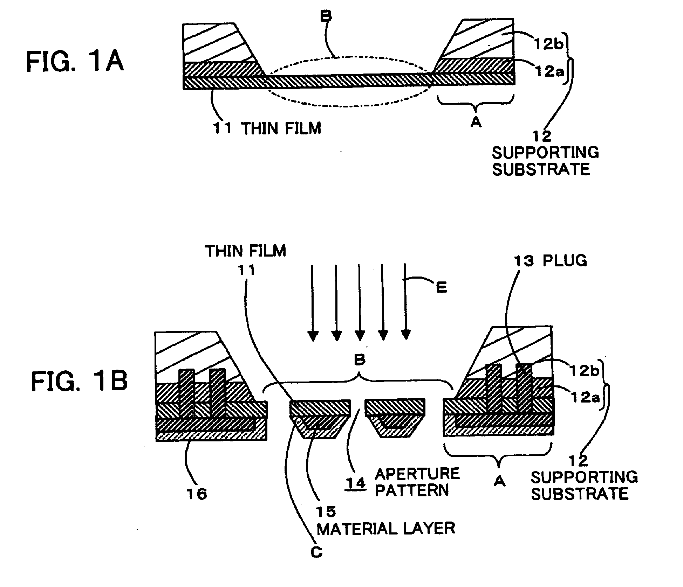

FIG. 1A is a schematic cross sectional view showing an example of the embodiment of a stencil mask in the present invention, and FIG. 1B is a cross sectional view showing the construction of the stencil mask. The stencil mask shown in these drawings is used for a technology of producing a semiconductor performing process such as an ion implantation process, an exposure process and so on at a processing substrate by irradiating a charged particle beam such as an ion, an electron beam and so on.

As shown in FIG. 1A, in the stencil mask of this embodiment a thin film 11 is placed in one side of a frame-shaped supporting substrate 12, the portion around the edge of this thin film 11 is supported with the supporting substrate 12. This portion supported with supporting substrate 12 is defined as a supporting portion A, a portion of the thin film 11 located in a frame of the supporting substrate 12 is defined as a membrane portion B. The supporting substrate 12 consists of an insulating film 12a and a substrate 12b, and is a laminated structure in which the substrate 12b is located in the portion around the edge of the thin film 11 through the insulating film 12a. Here, the thin film 11 is formed by, for example, silicon single crystal, the insulating film 12a is formed by silicon oxide, and the substrate 12b is formed by silicon single crystal.

Moreover, as shown in FIG. 1B, in the supporting portion A, a plug 13 is embedded in a state of penetrating the thin film 11 and reaches inside of the supporting substrate 12.

The plug 13 is formed by a material having heat conductance higher than that of the thin film 11 and the supporting substrate 12. As such a material, for example, a conductive material, such as aluminum, gold, silver, copper and so on, diamond and so on are considered. Here, the plug 13 is formed by a conductive material consisting of, for example, aluminum.

Moreover, the plug 13 is embedded in pillar-shaped, in a state of penetrating the thin film 11 and the insulating film 12a of the supporting substrate 12 and reaches inside of the substrate 12b, and a number of the plug 13 are embedded along the side of inner and outer circumferences of the frame-shaped supporting substrate 12.

Here, for improving a state of radiating heat of the stencil mask, it is so preferable that the occupied volume of the plug 13 in the supporting substrate 12 is large. Hence, it is so preferable that the plug 13 is embedded as deep as possible inside the supporting substrate 12, and that the cross sectional area of the plug 13 is large. Moreover, by embedding a number of plugs 13, the occupied volume of the plug 13 may be made larger.

Here, it is defined that a number of pillar-shaped plugs 13 is embedded along the side of inner and outer circumferences of the frame-shaped supporting substrate 12, however, for example, a frame-shaped plug 13 may be embedded along the frame-shaped 12, or a number of frame-shaped plugs 13 may be set from the side of inner circumferences to outer circumference of the supporting substrate 12.

Moreover, it is defined here that the plug 13 is set in a state of penetrating the thin film 11. However, if the heat generated in the surface of the thin film 11 is radiated rapidly through the plug 13, the plug 13 may be set in a state of not penetrating the thin film 11 but contacting the thin film 11. However, it is so preferable that the plug 13 is set in a state of penetrating the thin film 11, because, as mentioned later, a material layer 15 set on the opposite side of the surface on which the supporting layer 12 is set on the thin film 11 is made to be communicated with the plug 13.

Moreover, in the membrane portion B of the thin film 11, an aperture pattern 14 for passing a charged particle beam E is set. And, on the opposite side of the surface on which the supporting substrate 12 is set in the thin film 11, a material layer 15 for radiating the heat generated on the surface of the thin film 11 by irradiating the charged particle beam E is set. A protective film 16 for protecting the material layer 15 from the charged particle beam E in a state of covering the material layer 15 is set.

Here, in the present embodiment, the side of the surface on which the supporting substrate 12 is set in the thin film 11 is defined as the upper side of the thin film 11, the surface on which the material layer 15 is set is defined as the lower side of the thin film 11. This stencil mask is located in a state of aiming the material layer 15 at the side of the processing substrate and having a predetermined interval on the upper side of the processing substrate. The stencil mask is used by irradiating the charged particle beam E to the membrane portion B having the aperture pattern 14 from the upper side of the thin film 11. However, there may be the case that the supporting substrate 12 is set on the same side of the material layer 15, even if in that case, the stencil mask is used in a state of aiming the material layer 15 at the side of the processing substrate.

The material layer 15 is formed by a material having heat conductance higher than that of the thin film 11. Here, for example it is formed by a conductive material consisting of aluminum equivalent to the plug 13. As mentioned above, in the case that the material 15 is formed by a material equivalent to the plug 13, the material layer 15, that is similar to the plug 13, has heat conductance higher than that of the thin film 11 and the supporting substrate 12. As well, here the material layer 15 is formed by a material equivalent to the plug 13. However, it may be formed by a different material. In that case the material layer 15 may have a heat conductance higher than that of the thin film 11. However, it is preferable that the material layer 15 and the plug 13 are formed by the same material, because they can be formed in the same process.

Moreover, for example, the material layer 15 is set in the region except for a portion of outer edge C of the aperture pattern 14 in the lower side of the thin film 11. Here, for example the material layer 15 having an aperture pattern where the outer circumference shape of the aperture pattern 14 is expanded (not shown in the drawings) is set all over the region except for the portion of outer edge C of the aperture pattern 14 in the lower side of the thin film 11. And this material layer 15 is set not only in the membrane portion B having the aperture pattern 14 but on the thin film 11 constituting the supporting portion A continuously. The material layer 15 formed in the supporting portion A is in communication with the plug 13 in the state of contacting to the lower side of the plug 13 in the state of penetrating the thin film 11.

Here, the portion of outer edge C is the region where the charged particle diffracted on the edge of the aperture pattern 14, the charged particle reflected in the processing substrate and the materials emitted from the processing substrate by irradiating the charged particle frequently collide when placing the stencil mask on the upper side of the processing substrate with the material layer 15 aiming at the processing substrate and irradiating the charged particle beam E to the processing substrate through this stencil mask.

For preventing sputtering the material layer 15 by irradiating the charged particle beam E, it is preferable that the material layer 15 is set in the region except for this portion of outer edge C. Moreover, for preventing the temperature rising in the membrane portion B where the charged particle beam E is irradiated, it is preferable that the material layer 15 is set in as large range as possible containing the membrane portion B.

Moreover, it is preferable further that the material layer 15 is set from the membrane portion B to the supporting portion A continuously because it can be communicated with the plug 13. By making the material layer 15 to be in communication with the plug 13, the heat generated on the surface of the thin film 11 is radiated from the material layer 15 to the plug 13 and radiated through the plug 13 to inside of the supporting substrate.

For protecting the material layer 15 from the charged particle beam E and preventing lack of the material layer 15 by the heat or stress, the protective film 16 is set in a state of covering the surface of the material layer 15. The protective film 16 is set in such a manner that it does not affect the shape of the aperture pattern 14 set in the thin film 11. Moreover, it is preferable that the protective film 16 is formed by more durable material for the charged particle beam E than the material layer 15, such a material is a silicon nitride (SiN) film, a tetraethoxysilane (TEOS) film, a silicon single crystal film or an oxide film of the material layer 15 such as aluminum oxide and so on. Here, the protective film 16 is formed by a SiN film.

Moreover, here an example that the protective film 16 is set in a state of covering the material layer 15 is explained. However, if the material layer 15 is set in a state of not being exposed to the charged particle beam, the protective film 16 may not be set. However, for preventing generation of the contamination by sputtering the material 15 with the charged particle beam E more surely, it is preferable that the protective film 16 is set in a state of covering the material layer 15.

According to the stencil mask in connection with the present embodiment, the plug 13 having heat conductance higher than that of the thin film 11 and the support substrate 12 is embedded in a state of contacting with the thin film 11 and reaches inside of the supporting substrate 12. Hence, the heat generated in the thin film 11 by irradiating the charged particle beam E is radiated to the inside of the support substrate 12 quickly through the plug 13. Therefore, when placing the stencil mask on the upper side of the processing substrate with a predetermined interval and irradiating the charged particle beam E, the contact of stencil mask and the processing substrate because of deformation by the heat can be prevented, and the interval from the stencil mask in all region of the processing substrate can be kept. Further, since deformation of the aperture pattern 14 by the heat can be prevented, displacement and deformation of the region irradiating the charged particle beam E can be prevented. Moreover, in the case that the supporting substrate 12 is set to contact a cooling mechanism, since the cooled supporting substrate 12 quickly absorbs the heat of the thin film 11 through the plug 13, rising of the temperature of the thin film 11 can be prevented.

Moreover, according to the stencil mask of the present embodiment, in the side of the lower surface of the thin film 11, a material layer 15 having heat conductance higher than that of the thin film 11 is set. Hence, the heat generated in the surface of the thin film 11 by irradiating the charged particle beam E also can be radiated from the material layer 15 directly. Further, this stencil mask is set in a state where the plug 13 penetrates the thin film 11, the material layer 15 set on the lower side of the thin film 11 is set in communication with the plug 13. Hence the heat generated in the surface of the thin film 11 by irradiating the charged particle beam E is radiated from the thin film 11 to the material layer 15, and radiated from the material layer 15 through the plug 13 to the inside of supporting substrate 12 more quickly.

Further, according to the stencil mask of the present embodiment, the portion of outer edge C of the aperture pattern 14 is not covered by the material layer 15. Hence, even if the stencil mask is placed on the upper side of the supporting substrate by aiming the material layer 15 at the side of the processing substrate and the charged particle beam E is irradiated to the processing substrate through this stencil mask, exposing the material layer 15 to the charged particle beam E can be prevented. Hence, without the material layer 15 being sputtered by the charged particle beam E, generation of contamination can be avoided. Herewith, it can be prevented that the inside of a device of irradiating the charged particle beam E is contaminated by contamination. Moreover, since deposition of contamination to the surface of the processing substrate can be prevented, the problem of the device formed on the processing substrate can be resolved. Therefore, the yield of this device can be improved.

Moreover, by setting the protective film 16 in a state of covering the material layer 15, since sputtering the material layer 15 by the charged particle beam E is surely prevented and lack of the material layer 15 by the heat or stress is also prevented, generation of contamination can be prevented more surely.

Note that, in the present embodiment, an example that the material layer 15 set on the lower side of the thin film 11 is in communication with the plug 13 set in a state of penetrating the thin film 11 was explained. However, the present invention is not limited to this embodiment. If the heat generated in the surface of the thin film 11 can be radiated from the plug 13 to the supporting substrate 12, the material layer 15 may not be set on the lower side of the thin film 11 and the material layer 15 may not be in communication with the plug 13. However, it is so preferable that the material layer is set since the heat generated in the surface of the thin film 11 can be radiated from the material layer 15 directly. Further it is so preferable that the material layer 15 is communicated with the plug 13 since the heat generated in the surface of the thin film 11 can be radiated to the inside of the supporting substrate 12 more quickly.

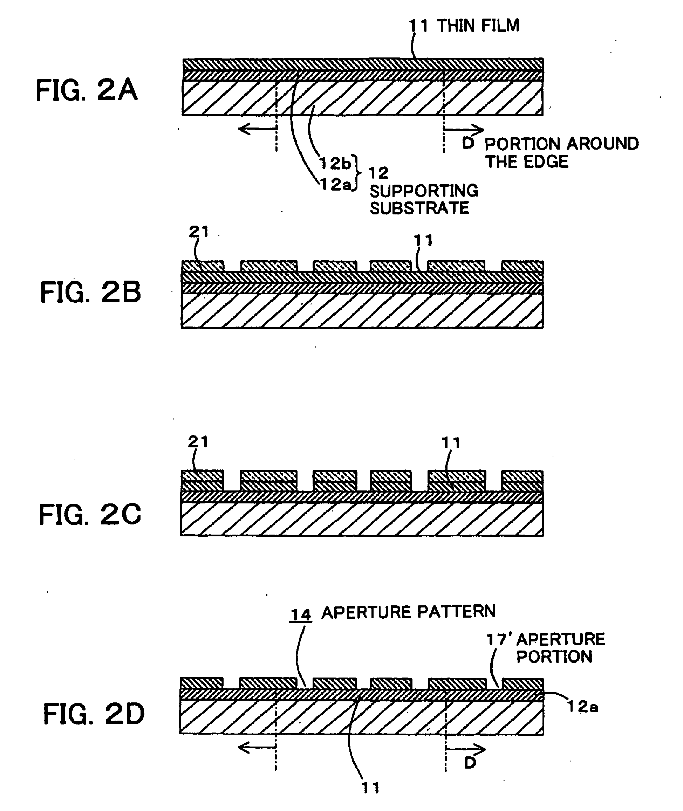

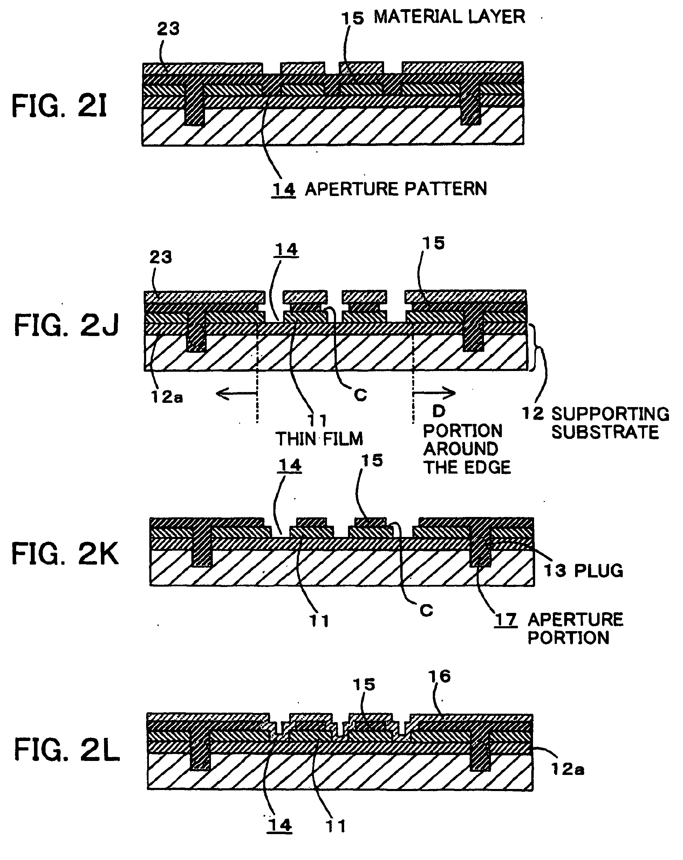

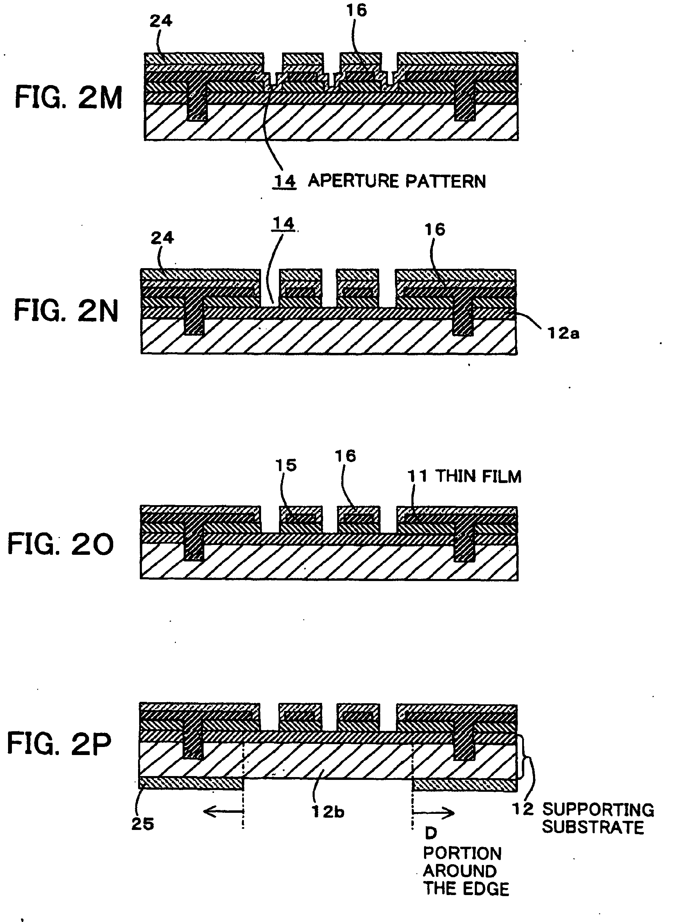

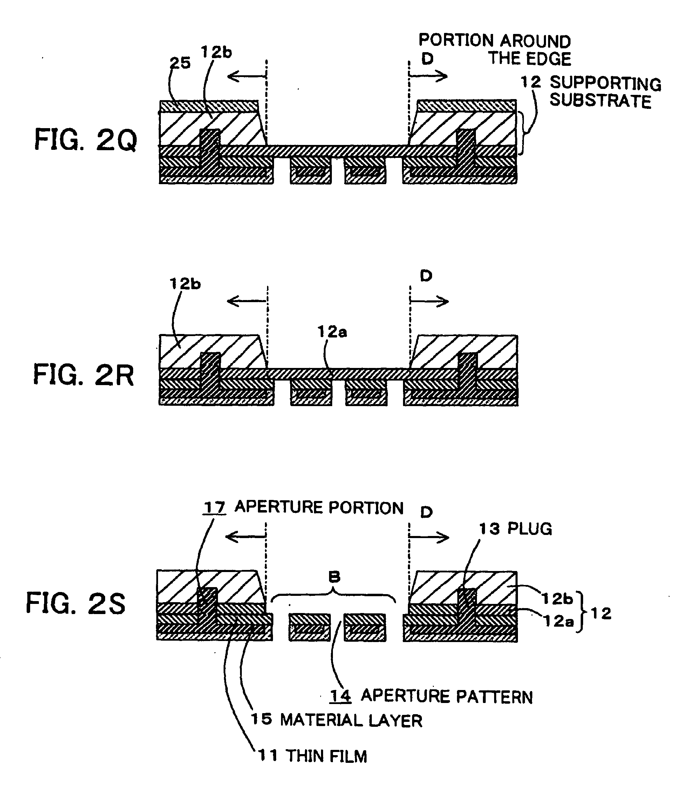

Next, an example of the embodiment in connection with a method of producing a stencil mask in the present embodiment will be explained with cross sectional views of manufacturing process of FIG. 2A to FIG. 2S.

First, as shown in FIG. 2A, a supporting substrate 12 is made by forming an insulating film 12a consisting of for example silicon oxide on a substrate 12b consisting of for example silicon single crystal. Afterward a thin film 11 consisting of for example silicon single crystal is formed on the insulating film 12a. Here the thin film 11 and the supporting substrate 12 have SOI, that is an abbreviation of Silicon on Insulator, construction.

Here, a portion around the edge D of the supporting substrate 12 and the thin film 11 on the portion around the edge D constitute the supporting portion A, that is referred to said FIG. 1A, the thin film inside the portion around the edge D constitutes the membrane portion B that is referred to FIG. 1A.

Next, as shown in FIG. 2B, a resist pattern 21 is formed on the thin film 11. Afterward, as shown in FIG. 2C, by an etching using the resist pattern 21 for the mask, the thin film 11 is removed. Afterward, the resist pattern 21 is removed. By the above process, as shown in FIG. 2D, an aperture pattern 14 reaching the insulating film 12a is formed in the thin film 11 covering inside the portion around the edge D of the supporting substrate 12 and an aperture portion 17' is formed in the thin film 11 covering the portion around the edge D of the supporting substrate 12. Here, since the plugs for radiating the heat generated in the thin film 11 are formed in the aperture portion 17' at post process, it is so preferable that the width of aperture is wide.

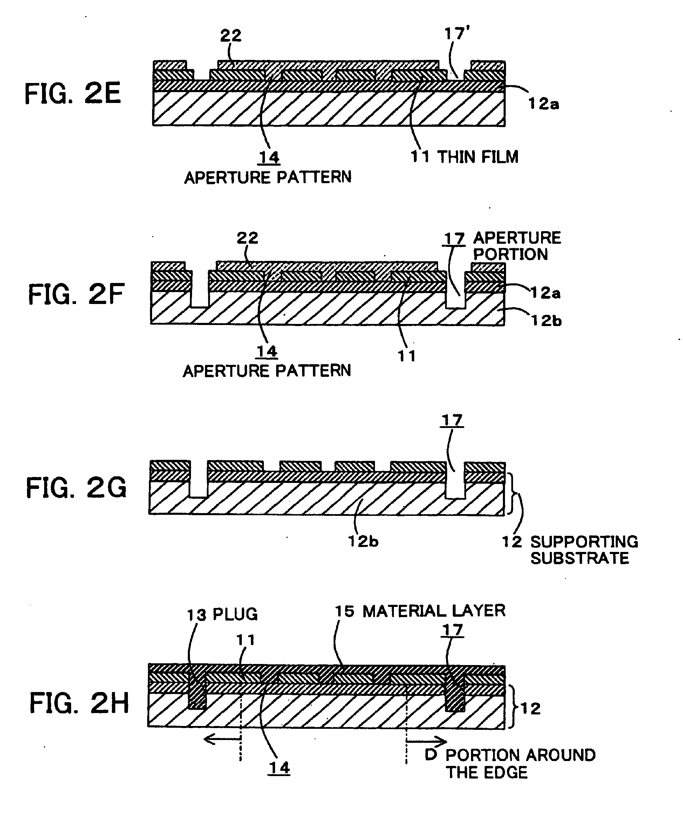

Next, as shown in FIG. 2E, in a state of covering the thin film 11 in which the aperture pattern 14 is set a resist pattern 22 is formed on the insulating film 12a to expose the aperture portion 17'. Afterward, as shown in FIG. 2F, by an etching where the resist pattern 22 is used as a mask, the insulating film 12a at the bottom of the aperture portion 17'and the substrate 12b are removed. After that, the resist pattern 22 is removed. Herewith, as shown in FIG. 2G, the aperture portion 17 is formed.

Here, the depth of the aperture portion 17 is not limited in particular, it may be as deep as a degree to embed a material for forming the plug sufficiently in the post process that the plug is formed in the aperture portion 17. However, it is preferable that the aperture portion is deeper, since the heat generated in the thin film 11 can be radiated from the plug to the supporting substrate 12 quickly because the plug formed in the aperture portion 17 can be formed longer.

Next, as shown in FIG. 2H, a material layer 15 is formed to cover the thin film 11 in which the aperture pattern 14 is formed and to embed the aperture portion 17. Here, the material layer 15 and the plug 13 are made to be formed by the same material, the plug 13 is formed by embedding the aperture portion 17.

Afterward, as shown in FIG.2I, a resist pattern 23 is formed on the material layer 15 to expose the material layer on the aperture portion 14. Next, as shown in FIG.2J, by an etching where the resist pattern 23 is used as a mask, the material layer 15 on the aperture pattern 14 is removed and the insulating film 12a is exposed, the material layer 15 covering the portion of outer edge C of the aperture pattern 14 in the thin film 11 is removed by over-etching. Moreover, in a state of continuing the material layer 15 on the thin film 11 covering inside of the portion around the edge D of the supporting substrate 12 the material layer 15 on the thin film 11 covering the portion around the edge D is left. Afterward, the resist pattern 23 is removed.

Herewith, as shown in FIG. 2K, the material layer 15 is formed to cover the region except for the portion of outer edge C of the aperture pattern 14 in the thin film 11, and the material layer 15 formed on the thin film 11 covering the portion around the edge D of the supporting substrate 12 and the plug 13 formed at the aperture portion 17 are set in communication with each other.

Next, as shown in FIG. 2L, by for example Plasma Enhanced Chemical Vapor Deposition (P-CVD) method, a protective film 16 consisting of for example silicon nitride film is formed on the insulating film 12a to cover the thin film 11 in which the aperture pattern 14 is set and the material layer 15.

Next, as shown in FIG. 2M, a resist pattern 24 is formed on the protective film 16 to expose the protective film 16 on the aperture pattern 14. Afterward, as shown in FIG.2N, by an etching where the resist pattern 24 is used as a mask, the protective film 16 on the aperture pattern 14 is removed and the insulating film 12a is exposed. After that, the resist pattern 24 is removed. Herewith, as shown in FIG. 20, the material layer 15 on the thin film 11 is in a state of being covered by the protective film 16.

Next, as shown in FIG. 2P, a resist pattern 25 is formed on the lower side of the substrate 12b in the portion around the edge of the supporting substrate 12. As shown in FIG. 2Q, the entire stencil mask is turned upside down. Afterward, by a dry-etching where the resist pattern 25 is used as a mask with using an etching gas such as for example carbon tetrafluoride or sulfur hexafluoride, the substrate 12b inside the portion around the edge D of the supporting substrate 12 is removed. After exposing the insulating film 12a inside the portion around the edge D, as shown in FIG. 2R, the resist pattern 25 is removed. As well, here the substrate 12b is removed by a dry-etching. However, the substrate 12b may be removed by a wet-etching where for example a solution of potassium hydroxide is used as an etchant.

Next, as shown in FIG. 2S, the thin film 11 is exposed by performing etching removal where this processed substrate 12b is used as a mask on the insulating film 12a inside the portion around the edge D of the supporting substrate 12 and the membrane portion B is formed.

According to the method of producing the stencil mask, as explained by using FIG. 2H, the material layer 15 is formed to cover the thin film 11 in which the aperture pattern 14 is formed and to embed the aperture portion 17. Herewith, the plug 13 that has a heat conductance higher than that of the thin film 11 and the supporting substrate 12, that is embedded in a state of penetrating the thin film 11 and that reaches inside of the supporting substrate 12 can be formed in the portion around the edge D of the supporting substrate 12. Moreover, by forming the plug 13 and the material layer 15 with the same material, the plug 13 and the material layer 15 can be formed at the same process.

Further, as explained by using FIG. 2J, by performing patterning on the material layer 15 since the material layer 15 covering the portion of outer edge C of the aperture pattern 14 of the thin film 11 is removed, the stencil mask in a state where the portion of outer edge C of the aperture pattern 14 is not covered by the material layer 15 can be manufactured. Moreover, by performing patterning on the material layer 15 since the material layer 15 is left on the thin film 11 covering the portion around the edge D of the supporting substrate 12, the material layer 15 is in communication with the plug 13 formed at the aperture portion 17.

As well, in the present embodiment, although an example where the plug 13 and the material layer 15 are formed by the same material and the plug 13 is formed by embedding the material layer 15 to the aperture portion 17 is explained, the material layer 15 and the plug 13 may be formed by different materials. In this case, as explained by using FIG. 2F, for example, the plug 13 is formed by embedding the material of forming a plug to the aperture portion 17, after forming the aperture portion 17 and before removing the resist pattern 22. Afterward, by forming a resist pattern, which is not shown in the drawings, to cover on the plug 13 after the resist pattern 22 is removed, the material layer 15 is formed to cover the thin film 11 in which the aperture pattern 14 is formed.

Moreover, in the present embodiment, an example where after forming the thin film 11 on the supporting substrate 12, the aperture portion 17 is formed in the thin film 11 covering the portion around the edge D of the supporting substrate 12 and the supporting substrate 12, the plug 13 is formed at the aperture portion 17 is explained. However, the method of producing the stencil mask of the present invention is not limited to this example. Before the thin film 11 is formed on the supporting substrate 12, the aperture portion 17 may be formed in the portion around the edge D of the supporting substrate 12, after the plug 13 is formed at the aperture portion, the thin film 11 is formed to cover the upper side of the plug 13 on the supporting substrate 12. Afterward by forming the aperture pattern 14 in the thin film 11 covering inside the portion around the edge D of the supporting substrate 12 and removing the supporting substrate 12 inside the portion around the edge D, the stencil mask is manufactured.

By such a method of producing the stencil mask, the plug 13 that has heat conductance higher than that of the thin film 11 and the supporting substrate 12, that is embedded in a state of contacting the thin film 11 and that reaches inside of the supporting substrate 12 can be formed in the portion around the edge D of the supporting substrate 12.

Note that the present invention is not limited to the above embodiments, but by the appended set of claims.

### INDUSTRIAL APPLICABILITY

The present invention can apply to application such as an ion implantation process, an exposure process, a process of forming a film or an etching process by irradiating a charged particle beam to a process substrate through a stencil mask in a state where a stencil mask is placed in the upper side of a processing substrate.

## Claims

1. A stencil mask comprising:
a thin film (11) having an aperture pattern (14); and
a supporting substrate (12) supporting a portion around the edge of said thin film (11), **characterized in that** it further comprises a plug (13) that is embedded in a state of contacting said thin film (11) and reaches inside of said supporting substrate (12) and has heat conductance higher than that of said thin film (11) and said supporting substrate (12).

2. A stencil mask as set forth in claim 1 further comprising:
a material layer (15) set on the side of a principal surface of said thin film (11) and having heat conductance higher than that of said thin film (11).

3. A stencil mask as set forth in claim 2, wherein said material layer (15) is in communication with said plug (13).

4. A method of producing a stencil mask as defined in claim 1 or claim 2 comprising:
a step of forming an aperture portion (17) in a portion around the edge of a supporting substrate (12);
a step of forming a plug (13) having heat conductance higher than that of a thin film (11) and said supporting substrate (12) at said aperture portion (17);
a step of forming a thin film (11) on the supporting substrate (12) to cover the upper side of said plug (13) to said supporting substrate (12);
a step of forming an aperture pattern (14) reaching said supporting substrate (12) on said thin film (11) covering inside the portion where the aperture portion (17) is formed around the edge of said supporting substrate (12), and
a step of removing a portion of the supporting substrate (12) inside the portion around the edge (D) of said supporting substrate (12) to expose said thin film (11).

5. A method of producing a stencil mask as set forth in claim 4, further comprising the following steps, after said step of forming said aperture pattern (14) and before said step of exposing said thin film (11):
a step of forming a material layer (15) having heat conductance higher than that of said thin film like covering said thin film in which said aperture pattern (14) is formed, and,
a step of removing said material layer (15) on said aperture pattern (14).

6. A method of producing a stencil mask as defined in claim 1 or claim 2 comprising:
a step of forming a thin film (11) on a supporting substrate (12);
a step of forming an aperture pattern (14) reaching said supporting substrate (12) in said thin film covering inside a portion around the edge of said supporting substrate (12) and forming an aperture portion (17) reaching inside of said supporting substrate (12) in said thin film covering the portion around the edge of said supporting substrate and said supporting substrate (12);
a step of forming a plug (13) having heat conductance higher than that of said thin film (11) and said supporting substrate (12) at said aperture portion (17), and;
a step of removing a portion of the supporting substrate (12) inside the portion around the edge of said supporting substrate (12) to expose said thin film (11).

7. A method of producing a stencil mask as set forth in claim 6, further comprising the following steps, after said step of forming said plug (13) and before said step of exposing said thin film (11);
a step of forming a material layer (15) having heat conductance higher than that of said thin film covering said thin film in which said aperture pattern (14) is formed, and,
a step of removing said material layer (15) on said aperture pattern (14).

8. A method of producing a stencil mask as set forth in claim 7, wherein a step of forming said plug (13) comprises:
a step of forming said material layer (15) to embed said aperture portion (17) and cover said thin film (11) in which said aperture pattern (14) is formed, and;
a step of removing said material layer (15) while leaving a portion of said material layer (15) remaining as said plug (13) at said aperture portion (17).

## Patentansprüche

1. Schablonemnaske, welche aufweist:
einen Dünnfilm (11), der ein Lochblendenmuster (14) hat; und
ein Lagersubstrat (12), welches einen Bereich rundum den Rand des Dünnfilms (11) lagert, **dadurch gekennzeichnet, dass** dies außerdem einen Stecker (13) aufweist, der in einem Zustand zum Kontaktieren des Dünnfilms (11) eingebunden ist und die Innenseite des Lagersubstrats (12) erreicht und eine Wärmeleitfähigkeit hat, die höher ist als die des Dünnfilms (11) und des Lagersubstrats (12).

2. Schablonenmaske nach Anspruch 1, welche außerdem aufweist:
eine Materialschicht (15), welche auf der Seite einer Hauptfläche des Dünnfilms (11) aufgebracht ist und eine Wännleitfähigkeit hat, welche höher ist als die des Dünnfilms (11).

3. Schablonenmaske nach Anspruch 2, wobei die Materialschicht (15) in Kommunikation mit dem Stecker (13) ist.

4. Verfahren zum Erzeugen einer Schablonenmaske nach Anspruch 1 oder 2, welches aufweist:
einen Schritt zum Bilden eines Lochblendenbereichs (17) in einem Bereich rundum den Rand eines Lagersubstrats (12);
einen Schritt zum Bilden eines Steckers (13), der eine VVärmleitfähigkeit hat, die höher ist als die eines Dünnfilms (11) und des Lagersubstrats (12) im Lochblendenbereich (17);
einen Schritt zum Bilden eines Dünnfilms (11) auf dem Lagersubstrat (12), um die obere Seite des Steckers (13) zum Lagersubstrat (12) zu überdecken;
einen Schritt zum Bilden eines Lochblendenmusters (14), welches das Lagersubstrat (12) auf dem Dünnfilm (11) erreicht, der die Innenseite des Bereichs überdeckt, wo der Lochblendenbereich (17) rundum den Rand des Lagersubstrats (12) gebildet ist, und
einen Schritt zum Beseitigen eines Bereichs des Lagersubstrats (12) innerhalb des Bereichs rundum den Rand (D) des Lagersubstrats (12), um den Dünnfilm (11) freizulegen.

5. Verfahren zum Erzeugen einer Schablonenmaske nach Anspruch 4, welches außerdem die folgenden Schritte nach dem Schritt zum Bilden des Lochblendenmusters (14) und vor dem Schritt zum Freilegen des Dünnfilms (11) aufweist:
einen Schritt zum Bilden einer Materialschicht (15), welches eine Wärmeleitfähigkeit hat, die höher ist als die des Dünnfilms, die den Dünnfilm überdeckt, in dem das Lochblendenmuster (14) gebildet ist, und
einen Schritt zum Beseitigen der Materialschicht (15) auf dem Lochblendenmuster (14).

6. Verfahren zum Erzeugen einer Schablonenmaske nach Anspruch 1 oder 2, welches aufweist:
einen Schritt zum Bilden eines Dünnfilms (11) auf einem Lagersubstrat (12);
einen Schritt zum Bilden eines Lochblendenmusters (14), welches das Lagersubstrat (12) in dem Dünnfilm erreicht, der die Innenseite eines Bereichs rundum den Rand des Lagersubstrats (12) überdeckt und einen Lochblendenbereich (17) bildet, der die Innenseite des Lagersubstrats (12) in dem Dünnfilm erreicht, der den Bereich rundum den Rand des Lagersubstrats und das Lagersubstrat (12) überdeckt;
einen Schritt zum Bilden eines Steckers (13), der eine Wärmeleitfähigkeit hat, die höher ist als die des Dünnfilms (11) und des Lagersubstrats (12) in dem Lochblendenbereich (17), und
einen Schritt zum Beseitigen eines Bereichs des Lagersubstrats (12) innerhalb des Bereichs rundum den Rand des Lagersubstrats (12), um den Dünnfilm (11) freizulegen.

7. Verfahren zum Erzeugen einer Schablonenmaske nach Anspruch 6, welches außerdem die folgenden Schritte vor dem Schritt zum Bilden des Steckers (13) und vor dem Schritt zum Freilegen des Dünnfilms (11) aufweist:
einen Schritt zum Bilden einer Materialschicht (15), welche eine Wärmeleitfähigkeit hat, die höher ist als die des Dünnfilms, die den Dünnfilm überdeckt, in welchem das Lochblendenmuster (14) gebildet ist, und
einen Schritt zum Beseitigen der Materialschicht (15) auf dem Lochblendenmuster (14).

8. Verfahren zum Herstellen einer Schablonenmaske nach Anspruch 7, wobei der Schritt zum Bilden des Steckers (13) aufweist:
einen Schritt zum Bilden der Materialschicht (15), um den Lochblendenbereich (17) einzubinden und um den Dünnfilm (11) zu überdecken, in welchem das Lochblendenmuster (14) gebildet ist, und
einen Schritt zum Beseitigen der Materialschicht (15), wo ein Bereich der Materialschicht (15) belassen wird, der als Stecker (13) in dem Lochblendenbereich (17) verbleibt.

## Revendications

1. Masque stencil comprenant :
un film mince (11) ayant un motif d'ouverture (14) ; et
un substrat support (12) supportant une partie autour du bord dudit film mince (11), **caractérisé en ce qu'**il comprend en outre une fiche (13) qui est noyée dans un état de contact avec ledit film mince (11) et atteint l'intérieur dudit substrat support (12) et a une conductance thermique supérieure à celle dudit film mince (11) et dudit substrat support (12).

2. Masque stencil selon la revendication 1, comprenant en outre :
une couche de matière (15) placée sur la face d'une surface principale dudit film mince (11) et ayant une conductance thermique supérieure à celle dudit film mince (11).

3. Masque stencil selon la revendication 2, dans lequel ladite couche de matière (15) est en communication avec ladite fiche (13).

4. Procédé de production d'un masque stencil selon la revendication 1 ou la revendication 2 comprenant :
une étape de formation d'une partie ouverture (17) dans une partie située autour du bord d'un substrat support (12) ;
une étape de formation d'une fiche (13) ayant une conductance thermique supérieure à celle d'un film mince (11) et dudit substrat support (12) au niveau de la partie ouverture (17) ;
une étape de formation d'un film mince (11) sur le substrat support (12) pour couvrir la face supérieure de ladite fiche (13) sur ledit substrat support (12) ;
une étape de formation d'un motif d'ouverture (14) atteignant ledit substrat support (12) sur ledit film mince (11) couvrant l'intérieur de la partie où la partie ouverture (17) est formée autour du bord dudit substrat support (12), et
une étape d'enlèvement d'une partie du substrat support (12) à l'intérieur de la partie autour du bord (D) dudit substrat support (12) pour mettre à nu ledit film mince (11).

5. Procédé de production d'un masque stencil selon la revendication 4, comprenant en outre les étapes suivantes, après ladite étape de formation dudit motif d'ouverture (14) et avant ladite étape de mise à nu dudit film mince (11) :
une étape de formation d'une couche de matière (15) ayant une conductance supérieure à celle dudit film mince, comme couvrant ledit film mince dans lequel ledit motif d'ouverture (14) est formé, et
une étape d'enlèvement de ladite couche de matière (15) sur ledit motif d'ouverture (14).

6. Procédé de production d'un masque stencil selon la revendication 1 ou la revendication 2, comprenant :
une étape de formation d'un film mince (11) sur un substrat support (12) ;
une étape de formation d'un motif d'ouverture (14) atteignant ledit substrat support (12) dans ledit film mince couvrant l'intérieur d'une partie située autour du bord dudit substrat support (12) et de formation d'une partie ouverture (17) atteignant l'intérieur dudit substrat support (12) dans ledit film mince couvrant la partie située autour du bord dudit substrat support et ledit substrat support (12) ;
une étape de formation d'une fiche (13) ayant une conductance thermique supérieure à celle dudit film mince (11) et dudit substrat support (12) au niveau de ladite partie ouverture (17), et ;
une étape d'enlèvement d'une partie du substrat support (12) à l'intérieur de la partie située autour du bord dudit substrat support (12) pour mettre à nu ledit film mince (11).

7. Procédé de production d'un masque stencil selon la revendication 6, comprenant en outre les étapes suivantes, après ladite étape de formation de ladite fiche (13) et avant ladite étape de mise à nu dudit film mince (11) :
une étape de formation d'une couche de matière (15) ayant une conductance supérieure à celle dudit film mince couvrant ledit film mince dans lequel ledit motif d'ouverture (14) est formé, et
une étape d'enlèvement de ladite couche de matière (15) sur ledit motif d'ouverture (14).

8. Procédé de production d'un masque stencil selon la revendication 7, dans lequel une étape de formation de ladite fiche (13) comprend :
une étape de formation de ladite couche de matière (15) pour noyer ladite partie ouverture (17) et couvrir ledit film mince (11) dans lequel ledit motif d'ouverture (14) est formé, et ;
une étape d'enlèvement de ladite couche de matière (15) tout en laissant une partie de ladite couche de matière (15) rester en tant que dite fiche (13) au niveau de ladite partie ouverture (17).
